# EUROPEAN PATENT APPLICATION

(11) **EP 2 472 600 A1**
(43) Date of publication of application: **04.07.2012**
(21) Application number: 10811260.8
(22) Date of filing: 24.08.2010
(51) Int. Cl.: H01L 31/052, F24J 2/46, H02N 6/00

(54) **SOLAR PHOTOVOLTAIC DEVICE AND SYSTEM**

(30) Priority: 24.08.2009 US 274888 P
(71) Applicant: Liao, Henry H., Taiwan 111 (CN)
(72) Inventor: Liao, Henry H., Taiwan 111 (CN)
(74) Representative: Schweiger, Martin
(86) International application number: PCT/CN2010/076298
(87) International publication number: WO 2011/023100

(57) **Abstract**

A quasi-parabolic solar photovoltaic system has a low concentration efficiency and great tolerance degree of a tracker pointing error. A quasi-parabolic reflection though concentrates the solar light on a narrow strip of a linear solar photocell array (12). A ling strip type solar plate (11) includes the linear solar photocell array (12) and a heat sink array (14). The long strip type solar plate (11) is fixed on a single axis or two-axis type solar tracker (10) by two support arms (18), and the height of the support arm (18) is adjustable. The quasi-parabolic solar photovoltaic system is composed of low cost quasi-parabolic reflection plates (52), a set of dense and low cost linear solar photocell array (12), and a single axis or two-axis type solar tracker (10) with loose requirement. The combination of these low cost technologies can reduce the production cost per kilowatt-hour of the solar photovoltaic system.

## Description

### BACKGROUND OF THE INVENTION

### 1. Field of the Invention

The present invention proposes a hybrid methodology and apparatus between photovoltaic (PV) and concentrated photovoltaic (CPV) solar panels to lower the photovoltaic solar energy production cost. In particular, the disclosed methodology addresses a simple quasi-parabolic trough PV (QPTPV) low concentration system with greater tolerance to tracker pointing errors. The quasi-parabolic trough (QPT) reflector is defocused to cover the width of a linear solar cells array, which is reduced from a large rectangular solar cells panel. In summary, the QPTPV system consists of low cost quasi-parabolic reflectors, a compact linear PV cells array and a lower cost relaxed pointing 2-axes or 1-axis tracker. The combination of these low cost technologies disclosed can achieve the lowest cost per kilowatt hour of photovoltaic energy production.

### 2. Description of the Prior Art

Photovoltaic (PV) solar panels are usually constructed with a two-dimensional matrix of solar cells packaged on a rectangular solar panel to accumulate solar energy without concentration and converted into utility electricity. Furthermore, if the solar panel is mounted on a 2-axes tracker facing the sun at all times, it can collect 40% to 50% more solar energy relative to a fixed panel. The PV panels commonly seen on residential roof are fixed silicon cells panels due to rooftop installation limitation. Silicon solar cells are much cheaper than other higher efficiency solar cells such as gallium based multiple-junction cells. The best silicon solar cells efficiency in the market today is better than 20% with laboratory solar cells reaching 25%. However, silicon solar panels without sun concentration require a large amount of silicon cells to cover the entire solar panel. Higher efficiency silicon cells (over 20%) are at higher cost since it is harder to make. Therefore, the rooftop solar panels are dominated by lower efficiency (15%-17%) silicon cells today. At year 2010, the retail silicon panel cost around US $2 per watt with rooftop installation cost around $5 to $6 per watt. If we propose a simplified approach of QPTPV system with 2-axes tracker to reduce the PV production cost to around $1 per watt, it is totally unconscionable by the industry today. This disclosure proposes a systematic methodology and apparatus to achieve exactly that lowest cost goal.

For concentrated photovoltaic (CPV) systems, the multiple-junction cells are much more expensive due to the scarcity of material and complicated processing steps and low yield. The triple-junction cell today can achieve twice the efficiency of single junction silicon cell to around 40% or higher. But the price of such cell is predominantly higher than the silicon cells; it requires high solar concentration of hundreds to thousands times (suns) to save cost of solar cell and achieve high efficiency at the same time. Therefore, the triple-junction solar cells today are cut into very small cell size around 1 square centimeter or less to save the cost of cell and rely on very high precision concentration optics to achieve high energy conversion efficiency. With the CPV systems, the requirement is that the solar panels must face the sun directly to collect sun rays with very high optical concentration using precision solar tracker. The cost of traditional high precision 2-axes solar tracker, the two stage concentration optics and cooling system together with high cost CPV cells constitute major cost items of CPV system. The installation cost per watt is much higher than PV panel today.

In PV systems when a solar tracker is used, it must cost less than 40% of solar panels; since the improvement in PV energy output with 2-axes tracker is around 40% to 50% depending on the latitude and fixed panel orientation of installation. With current 2-axes tracker on the market, the price has seldom been lower than 40% of the solar panels cost it carried. Therefore, 2-axes trackers are rarely used for PV panels unless it is mandated by a large solar farm. Therefore, there are more fixed panels or 1-axis trackers used in a large utility farm due to the high cost of 2-axes tracker today.

The tracker used for CPV system requires high pointing accuracy since the CPV cell is very small at around 1 square cm. Pointing error can easily misdirect the sun focus out of the small cell area. Even though some secondary optics or mirror funnel collector are used to mitigate the effect of pointing error, the solar tracker still requires high pointing accuracy with typical pointing requirement under 0.25 degree. On the contrary, the solar tracker used for flat PV panel does not require high pointing accuracy. The PV solar cells can collect sun energy at slanted angle such as used on rooftop panel. The efficiency is proportional to the cosine of slant angle of sun ray versus the normal line (perpendicular line) to the solar panel. For example, if the slant angle is 5 degree from normal, the efficiency is still 99.6% (i.e. cos 5°) of the perpendicular sun ray.

In summary, one can conclude that 2-axes tracker pointing requirement can be greatly relaxed for PV system. For example, the controller of PV tracker can use an open loop system with only memorized solar orbit sun position (sun almanac) without a sun sensor. Furthermore, it can use an output power measurement feedback pointing algorithm to achieve maximum output power proposed by this disclosure. The pointing resolution can be relaxed as long as it yields maximum output power. These relaxed pointing requirements can translate into lower cost for the tracker. In a separate patent application, we proposed several apparatus and systems which can dramatically reduce the cost of solar tracker.

### BRIEF SUMMARY OF THE INVENTION

With the above discussed backgrounds, the subject disclosure propose a system and apparatus different from PV or CPV systems of today to achieve the lower cost than any CPV or PV systems cost today.

In one aspect of the invention, the disclosed QPTPV system uses very low cost quasi-parabolic trough (QPT) reflectors. This disclosure proposes a simple technique to form so called QPT reflector. The QPT reflector does not yield high concentration ratio like a true parabolic trough or a dish parabolic reflector, but it is easily realizable with one piece naturally bended metal or plastic sheet reflector with front coated mirror. On top of the front coated mirror, weather protective coating and optional nano-material coating can be applied to prevent water and dust accumulation. In retail mirror market, a low cost glass mirror is commonly seen at the popular hardware stores. With bended sheet QPT reflector, it uses similar low cost mirror film with metal or composite backing and front dielectric protective coatings to enhance solar reflection.

In another aspect of the disclosure, the panel matrix consists of (6x12) array of solar cells. If a QPT reflector of the same span concentrates the sun rays onto a (1x12) linear cell array (strip), only one sixth of solar cells are needed. With the same reasoning, if the sun exposure area can be twice the span of the PV panel and concentrated on the same (1x12) linear cell array, only one twelfth of the solar cells are needed.

In yet another aspect of the disclosure, the low concentration ratio of 6 to 12 suns is at the lower end of achievable parabolic trough concentration. The tracker pointing accuracy can be relaxed by using output power measurement feedback pointing algorithm. This could reduce the 2-axes tracker cost, yet produce maximum energy output desired. Specifically, the pointing accuracy required by CPV system is typically under 0.25°. With relaxed pointing requirements around 1°, the lower cost 1-axis or 2-axes tracker is ideal for QPTPV applications. The relaxed pointing tracker uses a hybrid almanac tracker with output power measurement feedback to control the tracker pointing.

In addition, as an option to the QPTPV system, it can be doubled up as a water heating system. Normally, the concentrated PV system requires cooling to solar cells to operating temperature to function properly. Excessive cooling requirement is a burden to every CPV system. However, the linear solar panel can take advantage of linear array configuration and turn it into a linear water pipe heating system by using active cooling. By using active cooling, we can further absorb the escaped solar heat and transfer around 60% to 70% into water heating energy. The total absorbed solar energy of combined electricity and heating can reach 75% of sun energy based on the data of best commercial water heating system.

In CSP (concentrated solar power) application, a long concatenated parabolic trough is used to concentrate solar heat focusing on an insulated pipe to heat up water steam for a turbine electric generator. The parabolic trough today uses a large structure using shaped glass mirror or composite material reflectors. The QPT reflectors can be used in such parabolic trough using larger two halves QPT structure. Using QPT reflectors, the CSP structure will be lighter weight and lower cost for a simpler 1-axis tracker rotation.

In summary, the key to lower cost per watt of QPTPV system are; 1) Lower the cost of parabolic reflectors with simple QPT mirror reflector sheet, 2) Reduce the number of solar cells in linear array from 1/6 to 1/12 of the equivalent PV panel, 3) Lower the cost of 2-axes or 1-axis tracker with relaxed output power measurement feedback pointing algorithm. In this disclosure, the solar concentration is achieved from 6 to 12 times with low cost QPT reflectors made of bended sheet with mirror coating. The reduced number of linear array solar cells can afford to use more efficient silicon cells exceeding 20% efficiency. Together with low cost 2-axes tracker disclosed in previous patent application, it is entirely possible to achieve the target of US $1 per watt of photovoltaic solar energy production today.

These and other features, aspects and advantages of the present disclosure will become understood with reference to the following description, appended claims and accompany figures.

### BRIEF DESCRIPTION OF THE DRAWINGS

Fig. 1 illustrates a QPT reflector focused on linear strip of solar cells.
Fig. 2 illustrates end view of sun image reflection on a linear strip focal plane.
Figs. 3A-3C illustrate a large QPTPV system mounted on a 2-axes tracker.
Figs. 4A-4C illustrate a QPTPV system on 2-axes tracker with water heating option.
Fig. 5 illustrates a QPTPV system mounted on a 1-D tracker.
Fig. 6 illustrates the approach to combine low cost features of PV and CPV to derive lowest cost QPTPV system.

### DETAILED DESCRIPTION OF THE INVENTION

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures.

### QUASI-PARABOLIC TROUGH DEFINITION AND CONCENTRATION RATIO

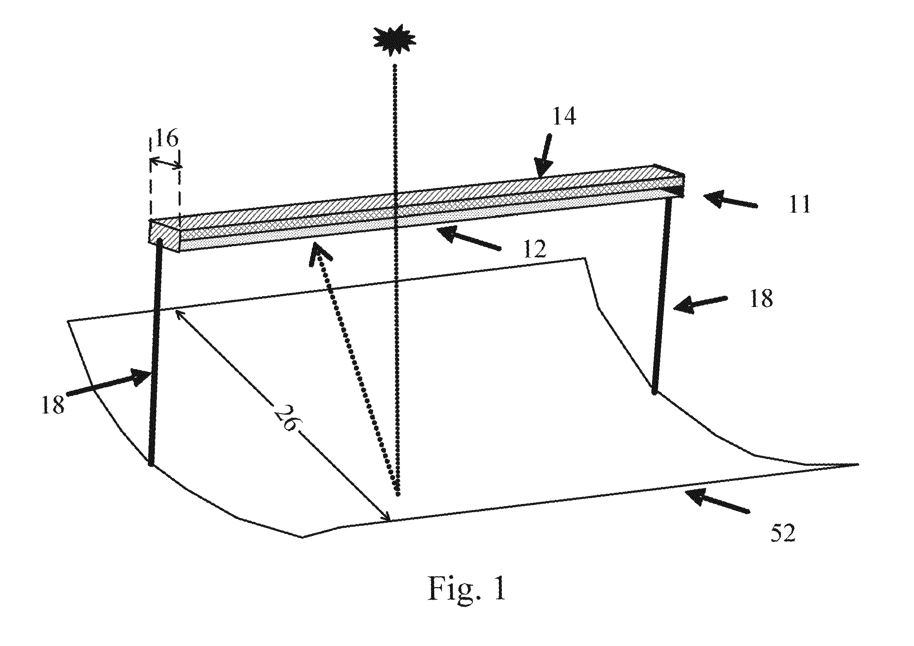

As shown in Fig. 1, the main aspect of the disclosure is to use a quasi-parabolic trough (QPT) reflector 10. The QPT reflector 10 uses one piece bended reflector sheet 52. Preferred QPT reflector uses rust proof sheet metal front mirror bended in natural shape. The bending force applied on both sides of the reflector sheet 52 would force the bending curve into natural quasi-parabolic shape. The reflector sheet 52 can also use fiberglass, plastic, acrylic, aluminum or aluminum composite, stainless steel sheet coated with front surface mirror and weather protective coating. Bended rigid glass or acrylic in a heated chamber is also possible. Either front or back mirror can be applied for clear sheet of rigid glass or acrylic reflector.

With true parabolic reflector, focusing a line on solar cell is not good for the solar cell since the sharp sun image may burn or damage the cell. The concentrated sun ray ideally must spread out evenly on the solar cell surface. This is usually done with non-imaging optics in the industry. Bending a flat sheet by pushing from both edges with specified rules will result in a quasi-parabolic trough (QPT) reflector proposed by this disclosure. When facing perpendicular to the sun, the QPT reflector will not focused the sun rays on a line, but rather on a linear strip on the linear solar cells array 12. This is similar to the effect of a cylindrical reflector which cannot focus parallel rays on a line. The linear solar panel 11 consists of linear solar cell array 12 and the back radiator array 14. If the focused strip is not wide enough to cover the solar cells array 12, intentional defocusing by moving the solar panel 11 closer to (or further from) the reflector sheet 52 would defocus the sun rays to fill up the linear area of solar cell array 12. This is the essence of this disclosure to achieve low QPT concentration ratio at lower cost than traditional parabolic trough. The back radiator array 14 is contacted directly with solar cell array 12 to dissipate accumulated heat from the cells due to solar concentration. The vertical arms 18, which hold the linear solar panel 11 in place, are adjustable in height from center line of reflector sheet 52. By adjusting the height of solar panel 11, a blurred image strip is yielded which can be varied in size until it spread evenly on the surface of linear solar cells array 12. Preferred height adjustment is done at installation to yield the maximum output power measurement from the solar cells array 12.

The parabolic linear span of reflector 52 along the bending direction is indicated by 26. The width of solar array 12 is indicated by 16. The solar concentration ratio (suns) of this system is the ratio of the reflector span width 26 subtracted by the array width 16 and divided by cell array width 16. The subtraction of linear array span 16 is due to the shading of array 12 on the reflector sheet 52, which discounts the reflecting area on the trough.

### METHOD OF MAKING QPT REFLECTOR AND A NUMERICAL EXAMPLE

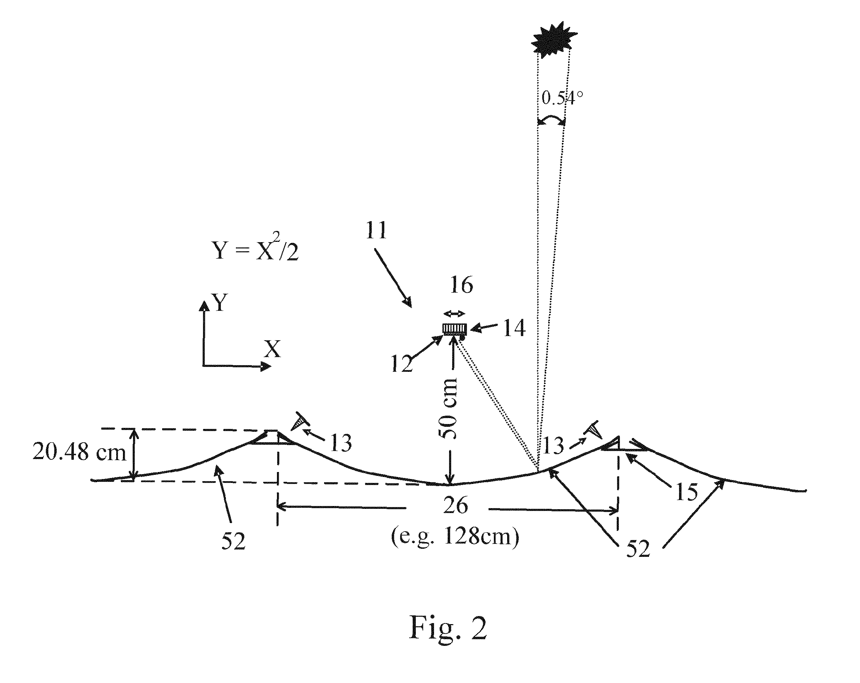

In Fig. 2, an example end view of QPT reflector is derived by a true parabolic equation Y = X²/2, where X indicates half the parabolic linear span, and Y indicate the bended depth of parabolic curve. The focus of parabolic curve is 0.5 meter above the center of parabolic curve in the example. If the parabolic linear span (2X) is 1.28 meter, the bending depth of parabolic curve below the linear parabolic span will be 0.2048 meter. In a perfect parabolic curve, the sun image will be focused on a line at ½ meter above the center of reflector.

To make a true parabolic trough with sheet metal or glass matching the parabolic curve is not easy. The true size molding and tooling must follow the parabolic curve exactly in order to bend the sheet metal or mold the flat glass to parabolic curve. The surface of the curve must be truly flat without material blemish. However, this invention discloses a simple low cost process of making a near parabolic trough which is defined as a quasi-parabolic trough (QPT) reflector. The QPT curve may not match the parabolic curve exactly due to material and process imperfection, but it is fairly close to true parabolic curve. Yet it can serve the purpose of low concentration PV as desired. In Fig. 2, the reflector sheet 52 is bended naturally with two edge secured by screws 13 between two triangular shaped mounting beams 15. Preferred embodiment of mounting beam is made from elongated metal strip bended into isosceles triangle cross section. The base isosceles angles shall match the slope of parabolic curve at mounting points with open seam at vertex angle. The purpose of open vertex is to allow bolting of the triangle beam onto tracker main frame with pillow clamp and bolts. The techniques of making a QPT reflector proposed by this disclosure shall follow these three rules closely;
1) The desired QPT linear span 26 shall be the distance between two mounting beams 15. The distance shall match the linear span 26 of a true parabolic curve closely.
2) The width of QPT reflector sheet 52 before bending shall closely match the true parabolic curve length between the parabolic span 26.
3) The two sloped edges of mounting beams 15 for the reflector sheet 52 shall match the slope of true parabolic curve closely at the point of contact. The contact points are securing with screws 13.

With these three closely matched parameters, i.e. span 26, a width 52 of the reflector sheet 52, and the slope of sloped edges of the mounting beam 15, the bended sheet reflector 52 would most likely become near parabolic shaped. We use the word "closely" to allow tolerance in mechanical processing. The bended reflector sheet is defined as a QPT matching closely to a true parabolic curve. As for imperfection, one can observe that the QPT sheet around the mounting point is linear which does not match true parabolic curvature exactly.

Alternatively to these three steps, the QPT reflector can be made by using symmetrical two halves of the parabolic curve; namely, the span 26 as well as the length of the reflector sheet 52 can be half of the span and width. Two halves of the symmetrical QPT reflectors will be jointed at the bottom by a center beam such as a reversed T-beam. The slope of sloped edges of the mounting beam 15 will match the parabolic curve for both QPT reflectors, but the bottom joint of two halves will be flat angle (zero degree slope). The alternative QPT technique can be used for larger QPT structure, or whenever flat sheet reflector is not large enough for one piece QPT curve. The larger QPT structure is useful for CSP (concentrated solar power) solar thermo concentrator. The disclosed quasi-parabolic curve forming techniques can achieve a lower cost than the parabolic reflector used by the CSP industry today.

The QPT bended sheet will focus the sun rays on a narrow strip rather than on a line due to bending curve imperfection. The width of the focused strip can be further widened by defocusing to fill up the linear cells array area. Preferred embodiment is to move the linear solar panel 11 closer to the reflector for defocusing with shorter height of vertical arm 18. In the numerical example of Fig. 2, if the span of reflector width 26 is 128 cm and the solar panel 11 width is 12.8 cm, the QPTPV solar concentration ratio is only 9 with solar panel shading deducted. This is in the lower range of achievable concentration ratio by a parabolic trough. Yet at this low concentration ratio, it only needs 11% of solar cells of equivalent area PV panel. This is one of the keys to lower the cost per watt of the QPTPV system.

For those skilled in the art, the QPT reflector can be bended in other geometric curve closely with the same three rules of sheet bending technique. For example, one can make a cylindrical trough reflector match closely to a circular arc curve with equivalent linear span, curve length and the slope at the mounting points. The cylindrical trough reflector could perform similarly to a QPT reflector but not as desirable as QPT reflector, since parallel rays reflect from cylindrical trough does not focus on a center line. Nevertheless, cylindrical trough is much easier to form than a parabolic trough. Other curved troughs are also possible, but is not as good as QPT reflector, or a cylindrical trough reflector. In general we shall define these bended troughs formed by the three rules of QPT forming as curved trough PV (CTPV) system imitating true geometric curve closely. Even though QPT reflector is most favored with focused strip, but cylindrical trough may be useful in low concentration application when linear cells array is fairly wide.

### EMBODIMENT OF A QPTPV SYSTEM ON 2-AXES TRACKER

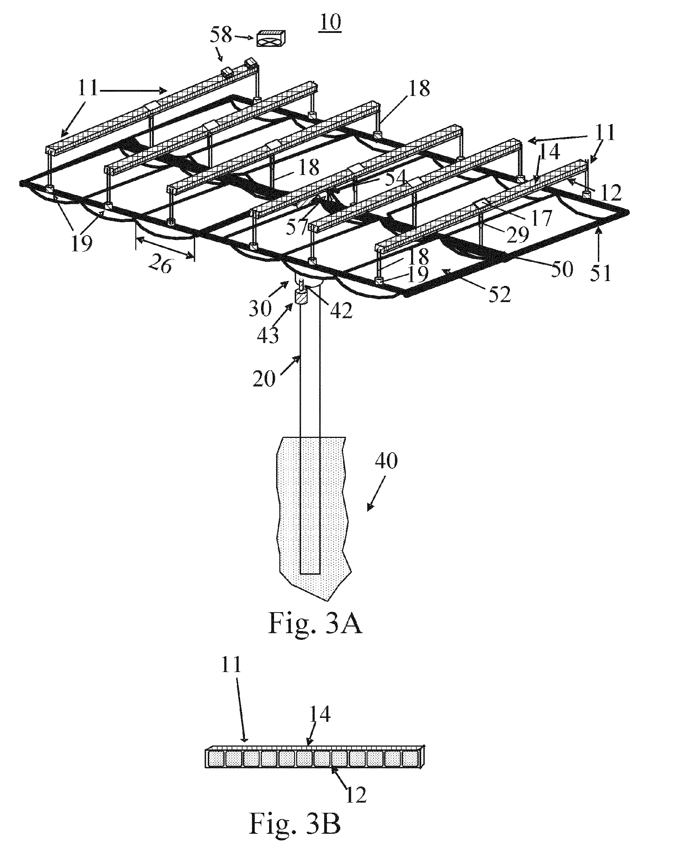

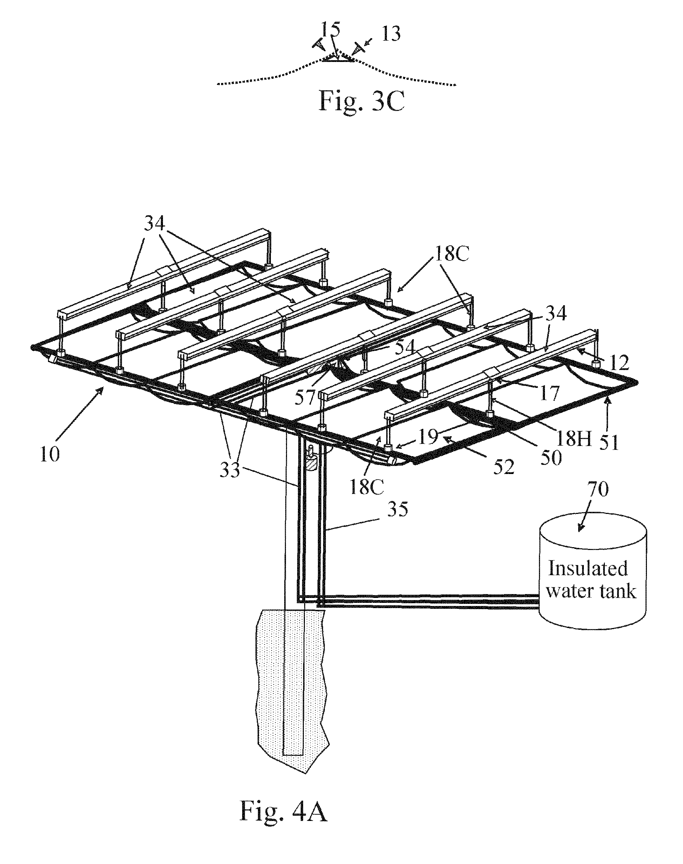

Fig. 3A illustrates a preferred embodiment of QPTPV system with multiple QPT reflectors mounted on a low cost 2-axes tracker 10. The 2-axes tracker 10 is disclosed in previous US patent application Ser. No. 12/852,454. The tracker 10 described is for ground installation with a ground post 20 secured on a base 40, or ground. On top of the ground post 20 is a rotating head 30. A horizontal beam 50 is secured on top of the rotating head 30. A two sided rectangular tracker frame 51 is attached and balanced on the horizontal beam 50. The isosceles cross section mounting beam 15 mounted in parallel on the horizontal beam 50 perpendicularly. The 2-axes tracker 10 in this embodiment uses a motor drive 43 and electro-magnetic rotor 42 attracted to rotating head 30 for azimuth rotation as an example. Various azimuth rotation techniques are disclosed in previous patent application. A linear actuator with jack head 57 shown is used for elevation rotation. The jack head 57 is hinged on 54 of the tracker frame. Each side of the tracker 10 is holding six quasi-parabolic reflectors 52. As depicted in Fig. 3C, each quasi-parabolic reflector 52 is mounted between isosceles triangular cross section beams 15 by pushing reflector sheet 52 into quasi-parabolic shape with securing metal screws 13 at both sides. The ends of beam 15 are attached with L-beams 5 at the edge to make a rectangular tracker frame 51. The linear solar panels 11 are held in place by vertical arms 18. Two aligned linear arrays 11 are met in the middle and joined with securing bracket 17 and supported by vertical arm 18 in the middle. The adjustment of height of vertical arm 18 in the middle may not be necessary since it is done at both ends of solar panels at edge L-beam 5. Therefore, the middle arm 18 can be inserted fittingly in a guiding tube 29 secured on bracket 17. The guiding tube 29 serves as a guiding rail. The bottom of middle arm 18 is secured on the tracker horizontal beam 50. The adjustment of the height of vertical arms 18 on both ends are sufficient to move the solar panels 11 up or down.

The defocusing of QPTPV is done by adjusting the height of vertical arms 18 attached on the edge L-beam 5 with screw nuts 19. The height adjustment can defocus the sun exposure evenly on the solar cells array 12 to yield maximum wattage output. Besides, defocusing can prolong the life of solar cell by not overheating the center of the cell by sharp sun image. Both height adjustments on arms 18 and mounting of reflector sheet 52 is done at tracker installation to yield maximum output power. This is quite different from traditional PV panel and CPV module installation with fixed factory calibration; which can be distorted while shipping and installation. As an example of on site calibration, if the linear length of reflector 52 is 2 meter with parabolic span of 1.28 m, which will exposed to 2560 watts of solar energy under ideal sun shine. With 20% efficiency of silicon solar cells array 12, 10% shading loss by linear solar panel and optical pass loss of 8 %, the QPTPV system can produce around 424 watts of electric power from each panel. If over 400 watts power is yielded, it is pretty good calibration.

The QPTPV system depicted in Fig. 3A is essentially a low concentration CPV system. As depicted in Fig. 3B, radiator array 14 at the back of solar panel 11 is needed to dissipate the excessive heat generated by the solar cells array 12. Optional solar fans 58 can be attached at the back of radiator 14 to speed up the radiation. These solar fans are low cost items seen on commercial solar fan caps. The solar cells normal operating temperature is 46°C with natural air radiation at the back of PV panel. Lower temperature will yields better performance, but it is hard to do with larger PV solar panel. But concentrated linear solar panel must have radiator to dissipate concentrated heat to achieve normal operating temperature. The radiator array looks similar to the radiator in the back of a window air conditioner. Since the ambient temperature is normally lower then 46°C in most part of the world, the radiator will radiate excessive heat into the air. Optional solar fans 58 can speed up the radiation and achieve a lower temperature at solar cells. This will produce higher output power from the solar cells array 12 than cells in regular PV panels. In addition, the solar fan 58 on top of solar panel 11 is constrained within the width of solar panel, which does not cause additional shading on the QPT reflector and supply its own power with solar cell at the back.

For traditional PV panel with 6x12 cell arrays, the silicon cells are usually connected in series to obtain higher voltage output for the inverter. In the example of Fig. 3A, it is designed with 6 panels of reflectors on each side. If linear cells arrays are connected in series, it is designed to yield similar output voltage as the traditional solar panel with roughly 9 times higher current. The design is to take advantage of commercial inverter designed for the traditional PV panels. However, it is not necessary to have 6 reflector panels on each side. It will be a design option to yield the best desired output power per tracker in a solar farm. Another way to boost the voltage output of linear cells array is to use fractional solar cells, such as half or quarter length cells. By connecting double or quadruple number of half or quarter cells, the output voltage can be doubled or quadrupled. Therefore, the design of linear solar cells array is flexible to yield any desired DC voltage.

In Fig. 3A, the reflectors 52 linear orientation is in elevation rotating direction while the reflectors 52 bending is toward azimuth rotation direction. The output power is more sensitive in the parabolic bending direction if miss focused; therefore the output power is more sensitive to azimuth rotation. Using azimuth rotation of 180 degree in 12 hours daylight for example, the rotation of 1 degree takes 4 minutes. We shall use a relaxed half degree resolution in 2 minutes period as an example of tracker activation. The initial pointing of the tracker will follow the sun orbit almanac at the date and time of the year. After initial pointing, the azimuth rotation motor 43 will continue step by step, backward and forward to measure the output power as feedback. If output power rise, the stepping motor 43 will go forward one more step until the power measurement go down, then it will back step to the maximum power point and stay idle. Next, the elevation rotation will be activated with the same procedure as azimuth rotation until maximum power is yielded. The azimuth and elevation activations are done in sequence in a relaxed 2 minutes period. Both azimuth and elevation rotation will stay idle between 2 minutes periodical activations. This is what we called a "relax pointing algorithm" since none of pointing accuracy in degrees or the stepping motor resolution in azimuth or elevation is specified as long as maximum power is yielded. We shall abbreviate the output power measurement feedback pointing algorithm as "maximum power pointing algorithm" hereafter. This will allows us to pick whatever reliable low cost actuators on the market. Using this power measurement feedback algorithm, the tracker does not have to verify the sun almanac unless it lost the pointing. However, the sun almanac can be verified frequently as an insurance check of the tracker pointing. The maximum power pointing algorithm can avoid using more expensive sun sensor as well as high precision actuators. In addition, the output power measurement may already exist in net-metering or feed-in-tariff (FIT) which measuring the power feed into utility grid lines. The maximum power pointing can be better than sun sensor or sun almanac pointing since neither the sun sensor nor the almanac pointing is linked to the output power production. The reflectors and linear solar panels may be misaligned with sun sensor or almanac pointing due to potential misalignment of some QPT reflectors or solar panels, especially after long term usage under adverse weather conditions. The maximum power pointing algorithm is indeed the best measure of the QPTPV system performance, and could lower cost of the tracker as well.

At this point, those skilled in the art may easily change the QPTPV structure in many ways. For example, the mounting beam does not have to be isosceles triangle as long as the mounting strip angle can match the parabolic curve slope at the point of mounting. In addition, the solar cell used is not limited to silicon cells or thin film cells. Other higher efficiency cells such as dual-junction cells or triple-junction cells can be used with higher concentration ratio. In this case, a larger QPT surface together with a secondary optics may be needed in the linear solar panel to boost the concentration ratio for expensive higher efficiency solar cells. This and other variation does not change the main sprit of described QPTPV system.

### EMBODIMENT OF A QPTPV SYSTEM WITH WATER HEATING

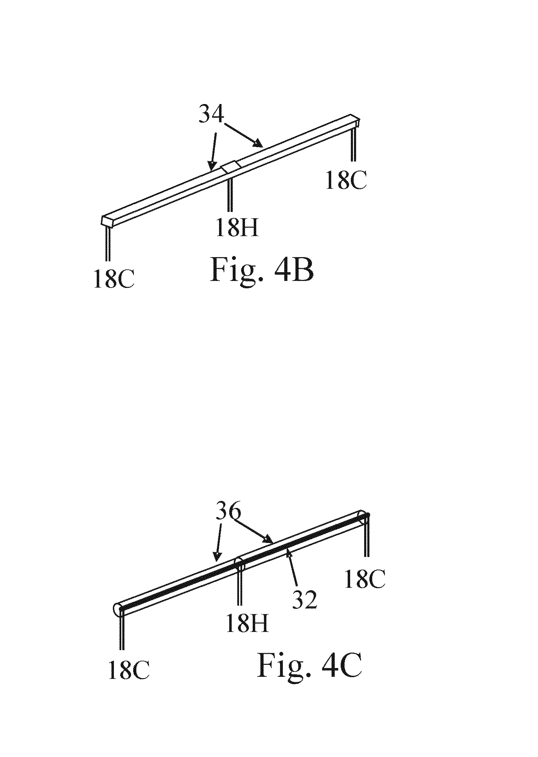

An alternative to passive radiator is using active liquid cooling as depicted in Fig. 4A. The active cooling system is a liquid (coolant) circulation system like automobile radiator. The cold liquid input plumbing is indicated by piping 33. Since the cooling system is not at high pressure, nor it is at high temperature, the plumbing can be flexible piping made of synthetic material used in the plumbing industry today. Flexible pipes leading to ground connection are easier for the 2-axes tracker in azimuth and elevation rotation. A flat metal radiator pipe 34 made of copper or aluminum heat conductor in close contact with linear solar cells array 12 is needed for concentrated heat dissipation. Circulation of cold liquid in radiator pipe 34 can cool down the linear solar cells array 12 to proper operating temperature and yield heated coolant output. In Fig. 4B, the vertical arms 18 supporting the linear solar panel 12 can be doubled up as water pipe connected to the radiator pipe 34. Preferred flow of cold liquid input pipe is indicated by 18C and heated water output indicated by 18H in the middle for easier hot water insulation. 18 H and the hot water pipe 35 flows into cold water tank 70 for heat exchange. With operating temperature of silicon cells at 46° C, it is ideal for household hot water output. This heated coolant pipe can perform heat exchange in a thermo insulated water tank 70 for household use similar to existing solar water heating systems. If higher temperature is needed, it can be further heated up from 46°C with other source of energy for cold weather or night time use.

The solar cells array operating temperature can be controlled with liquid coolant flow rate. Higher coolant flow rate may be needed in summer than winter, in high noon than morning and dawn. Lower operating temperature in solar cells array yields higher cell efficiency, and therefore higher output power. The energy produced by combination of PV energy and water heater energy could be balanced and optimized by controlling the coolant flow rate in the circulation system. Furthermore, the coolant used in the circulation can be either a closed loop coolant system with heat exchange at the water tank, or direct water circulation system in non-freezing weather. And the liquid used in freezing weather has to be anti-freeze coolant.

In the solar visible light spectrum, the shorter wave length energy is partially absorbed by the silicon cell and turned into electricity, longer wavelength near infrared spectrum and the escaped photons from silicon cells are turned into concentrated heat. An efficient thermo transfer system such as the concentrated solar system of Fig. 4A can yield high heat transfer efficiency in the 60 to 70% range at moderate temperature of 46°. As an example, if 20% of photons are absorbed by solar cells array 12 and turned into electricity, and the remaining 80% photons can heat up the pipe 34. With a conservative 60 % heat transfer efficiency, a total of 68% solar efficiency is achieved by the combined PV and heat solar energy system. Higher efficiency can be yielded by better insulating the heated area from ambient temperature.

Another application of the QPT reflectors is used for water heating only system as depicted in Fig. 4C. The linear solar cells panels are replaced with water heating pipe 32 fixed inside a transparent insulated tubing 36 as seen in some commercial solar water heating apparatus. Since the QPT reflectors are dedicated to concentrate heat into liquid pipe 32, the insulated heating device can be more efficient. Due to less number of insulated tubing 36 and heating pipe 32, the solar heating device can be lower cost than populated tubing systems. Besides, the low cost 2-axes tracker can generate more heat from sunrise to sunset on 2-axes tracker compared to a fixed panel solar water heater. The number of QPT reflectors will depend on the volume of hot water needed. In general, it does not require 12 panels as depicted in Fig. 4A for household use. Therefore, a smaller 2-axes tracker with two or more reflectors can be constructed for domestic solar water heating devices. In addition, the tracker pointing algorithm in the case of water heating system will use a thermostat temperature as the feedback to the maximum power pointing algorithm.

At this point, those skilled in the art may easily change the QPTPV structure of combined PV and heat system in many ways. For example, the hot water piping 35 as well heat conduction pipe 34 can use best insulation to yield lowest heat dissipation on the way to water tank. Also the input and output piping configuration can be optimized or shortened in many ways to prevent heat loss. This and other variations do not deviate from the essence of QPTPV system which can yield high efficiency of condensed heat transfer under the concentrated linear solar cells array.

### EMBODIMENT OF LONG PARABOLIC TROUGH ON 1-AXIS TRACKER

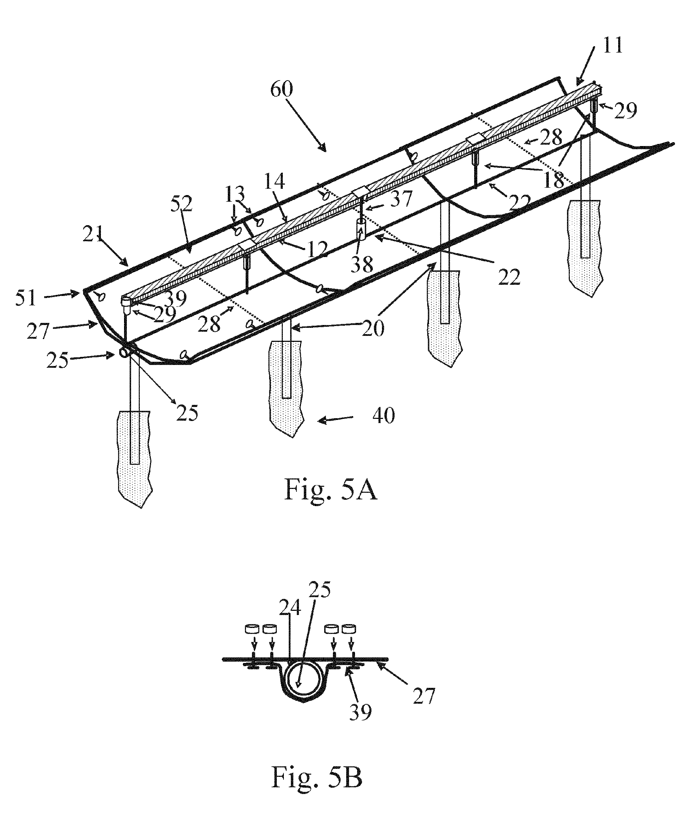

Fig. 5A illustrates a QPTPV system with multiple QPT reflectors mounted on a 1-axis tracker 60. The QPT reflectors 52 are concatenated for a long trough similar to a CSP parabolic trough system. Preferred QPT reflectors 52 are two halves construction surface joined by a T-beam 22 at the bottom. The seams at concatenation joints can use back side securing strips, or glue strips. One piece QPT can be used for smaller trough design. The concatenated reflectors 52 are secured on the mounting beams 21. One important feature for QPTPV on 1-axis tracker is that there shall be no gap between concatenated QPT reflectors 52, and there shall be no shading on the reflector surface other than the shading of linear solar panel 11 in the middle. Therefore, the tracker 60 structure and mounting frames 27 is under the QPT reflectors 52 with only two parallel mounting beams 21 shown on both sides of QPT reflectors 52. The bending of reflectors 52 follows three rules discussed in the QPT forming concept. Parallel mounting beams 21 on the mounting frame 27 are sloped at the screw points 13 matching true parabolic slope. There are multiple screws 13 to secure the bended reflectors 52 on the mounting beams 21. At both ends and the middle of QPT reflectors of the 1-axis tracker, multiple mounting frames 27 under the reflectors 52 are connected with the mounting beams 21 at both sides. An elongated reversed T-beam 22 is attached to the bottom center of mounting frame 27 to support two halves of QPT reflectors 52. Preferred embodiment of mounting frame 27 uses bended L-beam in three linear sections to form a reverse trapezoid shaped frame. The bending points can make cuts on L-beam and welded for rigid structure. Strengthened thin steel wires 28 can be used to tie between parallel mounting beams 21 for structure support. Since thin wire can be smaller than the sun angle shining on the reflector, the wire shading on reflector surface may disappear or become insignificant. This effect is commonly seen on electric poles without the shadow of thin electric wire under sunshine.

The linear solar panels 11 are mounted on multiple vertical arms 18 with linear cells array 12 at the front side facing the reflector 52. Vertical arms 18 are attached on the middle of T-beam 22 perpendicularly with adjustable height mechanism. At the back of linear solar cells array 12, a passive radiator array 14 is contacted directly with solar cell array 12 facing the sun direction. Solar fans attached to the back of solar panel 11 can be used for the radiator cooling. Alternative radiation using active liquid or water cooling is also possible. The active cooling system needs a water tank for the storage of heated water.

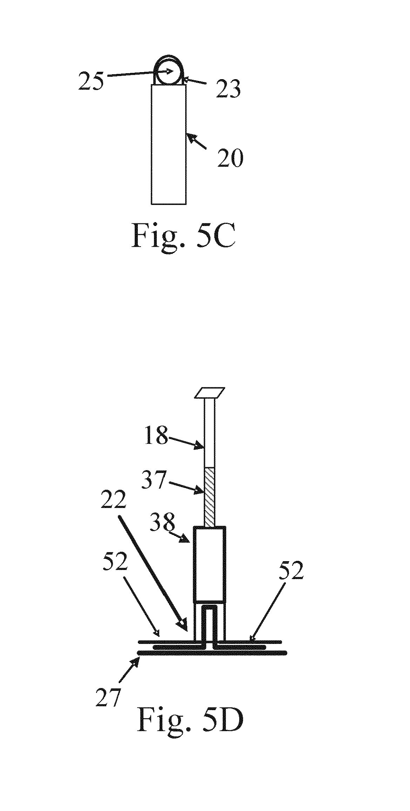

The entire tracker frame is secured and balanced on an elongated cylindrical beam 25 of the 1-axis tracker. The 1-axis tracker described herein with its rotating mechanism is filed in previous US patent application No. 12/816,195. In Fig. 5B the mounting frames 27 of the tracker 60 is mounted on the cylindrical beam 25 with a rotating bushing 24 in between and secured with a pillow clamp 39. The rotating bushing is looped on the cylindrical beam 25 facilitating 1-axis rotation of tracker frame 51. The cylindrical beam 25 is supported and fixed on multiple ground posts 20 as depicted in Fig. 5C. The two halves of reflector 52 are secured at the bottom on the reversed T-beam 22 as depicted in Fig. 5D. Preferred embodiment of the T-beam 22 uses elongated metal strip bended into T shaped beam. The QPT reflector 52 is joined at the center of reversed T-beam 22 and secured with screws. The reversed T-beam 22 is then attached between the mounting frames 27 and secured on the L-beam of mounting frame 27. The reversed T-beam 22 is aligned with the horizontal beam 25; which is sitting at the center line of gravity of the 1-axis tracker 60.

The one axis tracker rotation only takes care of daily sunrise to sunset solar tracking. There will be seasonal solar orbit change from summer to winter; which affect the focusing of the QPT reflectors. The orbit change is very slow motion at 0.26 degrees per day. To take care of this small change in solar orbit, the focal plane height of the linear solar panel 11 needs to be adjusted daily. A linear actuator 38 near the center of the 1-axis tracker is designed to move the vertical position of linear solar panel 11. More actuators at both ends can be used if the QPT reflector is of very long length such as used for CSP application. Also, it is also desirable to have two actuators at both ends of the tracker for a longer QPTPV system. The jack head 37 of linear actuator 38 is connected with center vertical arm 18 to move up or down the linear solar panel 11. The remaining vertical arms 18 need tight fit guiding rails for the vertical motion of solar panel 11. A fitted guiding tube 29 attached on the gaps of solar panels 12 and looped on the vertical arms 18 can serve the purpose of guiding rail. At the same time, tight fitting guiding tube 29 can ensure no lateral motion of the linear solar panel. Preferred embodiment use a cylindrical guiding tube 29 with inner wall coated with bushing material and lubricated with solid lubricant. The linear actuator(s) 38 will be activated a few times daily to adjust for the solar orbit change of 0.26 degree per day. The activation period of linear actuator 38 can be much longer than the 1-axis tracking activation period; however, it must also follows maximum power pointing algorithm. In addition, to further securing the vertical arms 18 on the solar panel 11, an electromagnetic locking coil looped on the guiding tube 29 can be installed. The electromagnetic locks are activated whenever linear actuator 38 is idle to lock up the vertical arms on the guiding tubes 29.

The concept of 1-axis linear QPTPV system can be used for the linear parabolic trough in concentrated solar power (CSP) industry. The CSP may need larger QPT reflector surface, but gaps and structure shadings are allowed in CSP systems. This feature will allow framing structure support in the gaps of QPT reflectors to support the long CSP steam pipe structure for continuous heat up of water steam used in CSP turbine generator.

Those skilled in the art can easily change the configuration QPT reflectors mounted on different type of 1-axis tracker or structure. For example, the simplified QPT reflectors can be mounted on traditional CSP structure. Also due to the light weight of QPT reflectors on the simplified tracker frame, the center heated tubing can be mounted on separated structure supported at both ends and middle of QPT reflector junctions. The only linkage will be the vertical arms 18 linked to the center heating tube. The vertical arms 18 serve as the radius of rotation around cylindrical beam 25. This will enable a simplified reflector structure with lighter rotating mechanism of the reflector. Also, since the heavier center steam pipe swings from sunrise to sunset with rotating actuator(s), the light weight tracker frame can be slaved to the same actuator(s) rotating around the cylindrical beam 25 with the linkage vertical arms 18 serves a radius of rotation. These variations do not change the essence of the disclosure with simple QPT reflectors.

### A SYSTEM APPROACH TO ACHIEVE LOWEST COST PER WATT

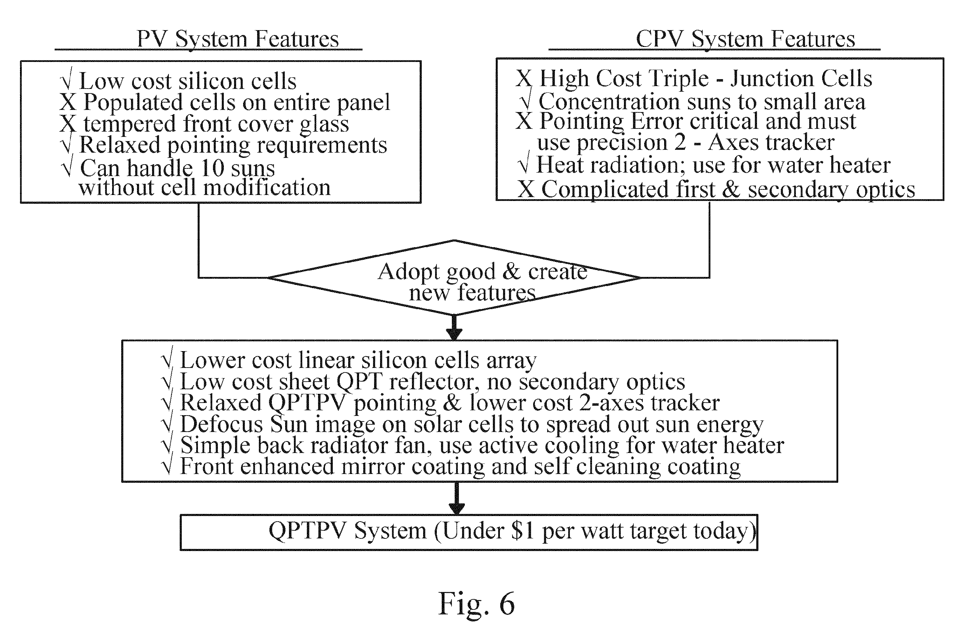

This disclosure intends to establish a system approach to reach lowest cost per watt target using overall lower combination cost. The system approach is illustrated in the flow diagram of Fig. 6. The approach takes good features from the PV and CPV systems and avoids bad features of both systems. This disclosure then creates a new approach to lower the overall combination cost of photovoltaic energy production. This system approach is not considered by the PV solar cell manufacturers today. Instead, each solar cell manufacturer acts independently in the pursuit of higher efficiency and lower cost PV solar cells, not considering the combination system power production cost. In general, the good features of PV systems are relative lower cost of silicon cells and relaxed pointing requirement in 2-axes tracking. Also low cost silicon cells today can operate at low concentration ratio with no loss of efficiency; and potentially improve the efficiency under concentration at lower operating temperature. The bad feature of PV panel is that too many cells are needed to populate the solar panel, which constitutes the majority of solar module cost. On the other hand, the good feature of CPV system is that it needs very few solar cells under high concentration. But the solar cell cost is very high, and the balance of system in concentration optics, high precision solar tracker and high cooling requirement are predominantly high cost. These are the main reasons that CPV solar systems are not as competitive as PV panel systems today.

The disclosed approach illustrated in Fig. 6 takes advantage of all the good features of PV and CPV systems and avoid the bad features, and then create a new system approach to create a very low cost QPTPV system, or CTPV system. In summary, the disclosed QPTPV or CTPV system approach uses only a fraction of solar panel PV cells, and takes advantage of relaxed tracker pointing requirement to lower the cost of a 2-axes tracker. In addition, a QPT or CT reflector bended by a flat sheet of font coated mirror is believed to be the lowest cost concentration method today. Furthermore, the heat radiation burden can be turned into a bonus water heating system which can achieve as high as 70% of solar energy utilization. Therefore, the proposed system approach is a combination of multiple low cost QPT or CT mirror reflectors mounted on a low cost 2-axes tracker with compact linear PV cells array. This combination system is the key to lower the cost of PV energy production targeted at US $1 dollar per watt today. Other good features disclosed including simple defocusing technique instead of complicated non-imaging optics to spread out the sun rays evenly on linear solar cells. And using maximum power pointing algorithm can lower the tracker cost and optimize the total energy output at the same time. In the case of water heating only or CSP systems, the output power can be replaced with digital thermostat to measure output liquid temperature as feedback for the tracker pointing.

Although various aspects of the disclosed approach and apparatus to lower cost of solar photovoltaic energy have been shown and described, modification may occur to those skilled in the art upon reading the specification. The present application includes such modifications and limited only by the scope of the claims.

## Claims

1. A quasi-parabolic trough photovoltaic (QPTPV) solar energy apparatus comprising;
multiple quasi-parabolic trough (QPT) reflectors mounted in the same orientation on the frame of a 2-axes solar tracker;
multiple linear solar cells arrays comprising serial connected PV solar cells; wherein each of said linear solar cells array is boxed in a rectangular linear solar panel; and said linear solar panel is attached to said tracker frame via two adjustable height mounting arms on both ends, and said mounting arms are perpendicular to said linear solar panel and said tracker frame; and each said linear solar cells array face said QPT reflector at the focal distance approximately;
wherein a linear passive radiator, or an active coolant linear flat pipe is attached to the back of each said linear solar cells array and secured inside said linear solar panel for heat dissipation; and
wherein said QPT reflectors focus on and concentrate solar rays on said solar cells arrays to produce photovoltaic power and, optionally, to produce heated water.

2. The QPTPV apparatus of claim 1
**characterized in that**
said QPT reflector is made from a flat sheet of mirror reflector bended into desired parabolic curve by a QPT forming technique; said QPT forming technique comprising 1) the linear span of said bended reflector matches closely to said parabolic curve linear span; 2) said reflector sheet width matches closely to said parabolic curve length between said linear span; 3) the mounting beams of said bended reflector sheet are angled to match closely the slope of said parabolic curve at the mounting points; and said QPT reflector is two halves of symmetrical QPT reflectors with junction in the middle at flat angle.

3. The QPTPV apparatus of claim 2
**characterized in that**
said QPT reflector is a cylindrical trough reflector; said cylindrical trough reflector is formed by identical three forming techniques as said QPT forming techniques matching circular curve parameters.

4. The QPTPV apparatus of claim 2
**characterized in that**
said QPT reflector sheets are made of bendable rust-proof metal sheet, stainless metal sheet, plastic sheet, acrylic sheet, fiberglass sheet, synthetic or aluminum composite sheet; said reflector sheets are coated with front mirror surface; and said QPT reflector is made of rigid glass or acrylic sheet formed by heated bending with front or back mirror.

5. The QPTPV apparatus of claim 1
**characterized in that**
said mounting arms of said linear solar panels is adjusted in height to spread out the sun rays evenly on said linear solar cells array in order to yield maximum output power.

6. The QPTPV apparatus of claim 1
**characterized in that**
the tracker azimuth and elevation rotation activation is performed periodically; and the pointing algorithm uses output power measurement as feedback in each period of the azimuth or elevation activations; and maximum power is achieved by forward and backward stepping by azimuth or elevation stepping motors in two separate sequences; and the azimuth and elevation stepping motors stay idle between activation periods.

7. The QPTPV apparatus of claim 1
**characterized in that**
the mounting beams of said QPT reflectors on said 2-axes tracker are isosceles triangles in cross section with two base angles of mounting beams matching said parabolic curve slope at the mounting points.

8. The QPTPV apparatus of claim 7
**characterized in that**
said mounting beams are made from elongated metal strip bended into isosceles triangle cross-section with open seam at the top vertex angle; and the base of said mounting beams are attached on top of a cylindrical horizontal beam of said 2-axes tracker with axis of elevation rotation centered on said horizontal beam.

9. The QPTPV apparatus of claim 1
**characterized in that**
the back of said linear solar panel is attached with multiple solar fans to cool down said passive radiators and said solar cells; and said solar fans are constrained to the width of said linear solar panel.

10. The QPTPV apparatus of claim 1
**characterized in that**
said active cooling flat pipes circulate coolant to a water tank with extended flexible piping for heat exchange inside said water tank; and the coolant flow rate is controlled to desired combination of PV and water heating energy production; and said coolant is water circulating said water tank directly.

11. The QPTPV apparatus of claim 10
**characterized in that**
said linear solar panel is replaced with an insulated liquid heating pipe for the purpose of water heating only.

12. A quasi-parabolic trough photovoltaic (QPTPV) solar energy apparatus comprising;
an elongated quasi-parabolic trough (QPT) reflector comprising multiple concatenated QPT reflectors mounted on the frame of an 1-axis solar tracker;
multiple linear solar cells arrays comprising serial connected PV solar cells; wherein each said linear solar cells array is boxed in a rectangular linear solar panel; and said linear solar panels are secured on adjustable height mounting arms which are perpendicular to said solar panels and said tracker frame; and said linear solar panels are connected into one elongated linear solar panel; and said linear solar cells arrays face said elongated QPT reflector at focal distance approximately;
wherein one or more selected said mounting arms of said elongated linear solar panel are connected to a linear actuators; wherein said linear actuators are fixed perpendicularly to said tracker frame; and the extension of said linear actuators adjust the height of said elongated linear solar panel;
wherein the remaining said mounting arms are inserted fittingly inside guiding tubes attached to the sides and gaps of said linear solar panels; and said elongated linear solar panel is moved up or down along the guiding tubes with the activations of said linear actuator(s);
wherein a linear passive radiator array, or a circulating liquid cooling flat pipe is attached to the back side of each said linear solar cells array and secured inside said linear solar panel box for heat dissipation;
wherein said elongated QPT reflector focus on and concentrate solar rays on said linear solar cells arrays to produce photovoltaic power and optionally, to produce heated water.

13. The QPTPV apparatus of claim 12
**characterized in that**
said QPT reflector is made from a flat sheet of mirror reflector bended into desired parabolic curve by a QPT forming technique; said QPT forming technique comprising 1) the linear span of said bended reflector matches closely to said parabolic curve linear span; 2) said reflector sheet width matches closely to said parabolic curve length between said linear span; 3) the mounting beams of said bended reflector sheet are angled to match closely the slope of the parabolic curve at the mounting point; and said QPT reflector is two halves of symmetrical QPT reflectors with junction in the middle at flat angle.

14. The QPTPV apparatus of claim 13
**characterized in that**
said QPT reflector sheets are made of bendable rust-proof metal sheet, stainless metal sheet, plastic sheet, acrylic sheet, fiberglass sheet, synthetic or aluminum composite sheet; said reflector sheets are coated with front mirror surface; and said QPT reflector is made of rigid glass or acrylic sheet formed by heated bending with front or back mirror.

15. The QPTPV apparatus of claim 12
**characterized in that**
the tracker pointing algorithm uses output power measurement as feedback to 1-axis solar tracker rotation to achieve maximum output power; and the mounting height of said linear solar panels are adjusted daily to accommodate solar orbit change using said output power measurement as feedback to achieve maximum power output.

16. The QPTPV apparatus of claim 12
**characterized in that**
optional electromagnetic locks are installed on said guiding tubes to lock up said mounting arms and said linear solar panels between said linear actuator activation periods.

17. The QPTPV apparatus of claim 12
**characterized in that**
the back side of said solar panel is attached with multiple solar fans for the cooling of said passive radiators and said solar cells; and said solar fans are constrained to the width of said linear solar panel.

18. The QPTPV apparatus of claim 12
**characterized in that**
said circulating liquid flat pipe is connected to a water tank with extended flexible piping for heat exchange inside said water tank; and the coolant flow rate is controlled to desired combination of PV and water heating energy production; and said coolant is water circulating said water tank directly.

19. The QPTPV apparatus of claim 18
**characterized in that**
said linear solar panels are replaced with an insulated liquid coolant heating pipes connected for the purpose of heating water only.

20. The QPTPV apparatus of claim 12
**characterized in that**
said linearly concatenated QPT reflectors is used for concentrated solar power (CSP) system reflectors; said elongated linear solar panel is replaced by an insulated heating pipe carrying heated steam for electricity generation.

21. A quasi-parabolic trough photovoltaic QPTPV system comprising;
one or more curved trough reflectors mounted in the same orientation on the frame of a 2-axes or 1-axis tracker; wherein said curved trough reflectors is a QPT reflector, a cylindrical trough reflector or a curved trough reflector bending to a geometric curve closely;
one or more linear solar cells arrays comprising serial connected PV solar cells contained in a linear rectangular solar panel with passive or active heat radiation devices;
wherein said linear solar panels are mounted on said 2-axes or 1-axis tracker frame with manual or automatic adjustable height mounting arms perpendicular to said solar panel(s);
wherein said curved trough reflectors concentrate sun rays on said linear solar cells arrays to produce photovoltaic power and, optionally, to produce heated water.

22. The CTPV system of claim 21
**characterized in that**
said curved trough reflector is made from a flat sheet of mirror reflector bended into desired geometrical curve by a curved trough forming technique; said curved trough forming technique comprising 1) the linear span of said bended reflector matches closely to said geometrical curve linear span; 2) said reflector sheet width matches closely to said geometric curve length between said linear span; 3) the mounting beams of said bended reflector sheet are angled to match closely the slope of said geometric curve at the mounting point; and said curved trough reflector is two halves of symmetrical curved trough reflectors with junction in the middle at flat angle.

23. The CTPV system of claim 21
**characterized in that**
the combination technologies of 1) using said curved trough reflectors mounted on 2-axes or 1-axis solar tracker, 2) using said curved trough reflectors concentrating solar rays onto said linear solar cells array or heating pipe, 3) using output power measurement (or output thermostat temperature in water heating) as feedback to a maximum power pointing algorithm; said combination technologies, or partial combination technologies, is used to save the cost of solar energy production.

24. The CTPV system of claim 21
**characterized in that**
said adjustment of solar panels height are used to spread out sun rays evenly on said linear solar cells array to achieve maximum solar output power.

25. The CTPV system of claim 21
**characterized in that**
multiple solar fans are attached on the back of said linear solar panel to speed up heat radiation; and said solar fans are constrained to the width of said linear solar panel.

26. The CTPV system of claim 21
**characterized in that**
said active radiation device is doubled up as solar water heating device.

27. The CTPV system of claim 21
**characterized in that**
said linear solar panels are replaced with insulated solar heating pipes for the purpose of water heating only.

28. The CTPV system of claim 21
**characterized in that**
said curved trough reflectors mounted on 1-axis tracker are used for solar power (CSP) system with replacement of said elongated linear solar panel by an insulated linear solar heating pipe generating steams for turbine power generation.

## Amended claims

### Amended claims under Art. 19.1 PCT

**1.** A quasi-parabolic trough photovoltaic (QPTPV) solar energy apparatus **characterized in that** said QPTPV solar energy apparatus comprises:
multiple quasi-parabolic trough (QPT) reflectors mounted in the same orientation on the frame of a 2-axes solar tracker, wherein each QPT reflector is made from a flat sheet of mirror reflector bended into desired parabolic curve by a QPT forming technique; said QPT forming technique comprising:
1) the linear span of said bended reflector matches closely to said parabolic curve linear span;
2) said bended reflector width matches closely to said parabolic curve length between said linear span;
3) mounting beams of said bended reflectors are angled to match closely the slope of said parabolic curve at the mounting points; and said QPT reflector is, optionally, two halves of symmetrical QPT reflectors with junction in the middle at flat angle;
multiple linear solar cells arrays comprising serial connected PV solar cells; wherein each of said linear solar cells array is boxed in a rectangular linear solar panel; and said linear solar panel is attached to said tracker frame via two adjustable height mounting arms on both ends, and said mounting arms are perpendicular to said linear solar panel and said tracker frame; and each said linear solar cells array face said QPT reflector at the focal distance approximately;
wherein a linear passive radiator, or an active coolant linear flat pipe is attached to the back of each said linear solar cells array and secured inside said linear solar panel for heat dissipation; and
wherein said QPT reflectors focus on and concentrate solar rays on said solar cells arrays to produce photovoltaic power and, optionally, to produce heated water.

**2.** The QPTPV apparatus of claim 1
**characterized in that**
said QPT reflector is a reflector bended into desired geometrical curve by a curved trough forming technique; said curved trough forming technique comprising:
(a) the linear span of said bended reflector matches closely to said geometrical curve linear span;
(b) said reflector sheet width matches closely to said geometric curve length between said linear span;
(c) the mounting beams of said bended reflectors are angled to match closely the slope of said geometric curve at the mounting point.

**4.** The QPTPV apparatus of claim 2
**characterized in that**
said QPT reflector sheets are made of bendable rust-proof metal sheet, stainless metal sheet, plastic sheet, acrylic sheet, fiberglass sheet, synthetic or aluminum composite sheet; said reflector sheets are coated with front mirror surface; and said QPT reflector is, optionally, made of rigid glass or acrylic sheet formed by heated bending with front or back mirror.

**5.** The QPTPV apparatus of claim 1
**characterized in that**
said mounting arms of said linear solar panels is adjusted in height to spread out the sun rays evenly on said linear solar cells array in order to yield maximum output power.

**6.** The QPTPV apparatus of claim 1
**characterized in that**
the tracker azimuth and elevation rotation activation is performed periodically; and the pointing algorithm uses output power measurement as feedback in each period of the azimuth or elevation activations; and maximum power is achieved by forward and backward stepping by azimuth or elevation stepping motors in two separate sequences; and the azimuth and elevation stepping motors stay idle between activation periods.

**7.** The QPTPV apparatus of claim 1
**characterized in that**
the mounting beams of said QPT reflectors on said 2-axes tracker are isosceles triangles in cross section with two base angles of mounting beams matching said parabolic curve slope at the mounting points.

**8.** The QPTPV apparatus of claim 7
**characterized in that**
said mounting beams are made from elongated metal strip bended into isosceles triangle cross-section with open seam at the top vertex angle; and the base of said mounting beams are attached on top of a cylindrical horizontal beam of said 2-axes tracker with axis of elevation rotation centered on said horizontal beam.

**11.** The QPTPV apparatus of claim 8
**characterized in that**
said linear solar panel is replaced with an insulated liquid heating pipe for the purpose of water heating only.

**12.** A quasi-parabolic trough photovoltaic (QPTPV) solar energy apparatus **characterized in that** said QPTPV solar energy apparatus comprises:
an elongated quasi-parabolic trough (QPT) reflector comprising multiple concatenated QPT reflectors mounted on the frame of an 1-axis solar tracker; wherein each QPT reflector is made from a flat sheet of mirror reflector bended into desired parabolic curve by a QPT forming technique; said QPT forming technique comprising:
1) the linear span of said bended reflector matches closely to said parabolic curve linear span;
2) said bended reflector width matches closely to said parabolic curve length between said linear span;
3) mounting beams of said bended reflectors are angled to match closely the slope of said parabolic curve at the mounting points; and said QPT reflector is two halves of symmetrical QPT reflectors with junction in the middle at flat angle;
multiple linear solar cells arrays comprising serial connected PV solar cells; wherein each said linear solar cells array is boxed in a rectangular linear solar panel; and said linear solar panels are secured on adjustable height mounting arms which are perpendicular to said solar panels and said tracker frame; and said linear solar panels are connected into one elongated linear solar panel; and said linear solar cells arrays face said elongated QPT reflector at focal distance approximately;
wherein one or more selected said mounting arms of said elongated linear solar panel are connected to a linear actuators; said linear actuators are fixed perpendicularly to said tracker frame; and the extension of said linear actuators adjust the height of said elongated linear solar panel;
wherein the remaining said mounting arms are inserted fittingly inside guiding tubes attached to the sides and gaps of said linear solar panels; and said elongated linear solar panel is moved up or down along the guiding tubes with the activations of said linear actuators;
wherein a linear passive radiator array, or a circulating liquid cooling flat pipe is attached to the back side of each said linear solar cells array and secured inside said linear solar panel box for heat dissipation;
wherein said elongated QPT reflector focus on and concentrate solar rays on said linear solar cells arrays to produce photovoltaic power and optionally, to produce heated water.

**13.** The QPTPV apparatus of claim 12
**characterized in that**
said QPT reflector is a reflector bended into desired geometrical curve by a curved trough forming technique; said curved trough forming technique comprising:
(a) the linear span of said bended reflector matches closely to said geometrical curve linear span;
(b) said reflector sheet width matches closely to said geometric curve length between said linear span;
(c) the mounting beams of said bended reflectors are angled to match closely the slope of said geometric curve at the mounting point.

**14.** The QPTPV apparatus of claim 12
**characterized in that**
said QPT reflector sheets are made of bendable rust-proof metal sheet, stainless metal sheet, plastic sheet, acrylic sheet, fiberglass sheet, synthetic or aluminum composite sheet; and said reflector sheets are coated with front mirror surface; and said QPT reflector is, optionally, made of rigid glass or acrylic sheet formed by heated bending with front or back mirror.

**15.** The QPTPV apparatus of claim 12
**characterized in that**
the tracker pointing algorithm uses output power measurement as feedback to 1-axis solar tracker rotation to achieve maximum output power; and the mounting height of said linear solar panels are adjusted daily to accommodate solar orbit change using said output power measurement as feedback to achieve maximum power output.

**19.** The QPTPV apparatus of claim 12
**characterized in that**
said linear solar panels are replaced with an insulated liquid coolant heating pipes connected for the purpose of heating water only.

**20.** The QPTPV apparatus of claim 12
**characterized in that**
said linearly concatenated QPT reflectors is used for concentrated solar power (CSP) system reflectors; said elongated linear solar panel is replaced by an insulated heating pipe carrying heated steam for electricity generation.

**21.** A quasi-parabolic trough photovoltaic (QPTPV) system **characterized in that** said QPTPV system comprises:
one or more curved trough reflectors mounted in the same orientation on the frame of a 2-axes or 1-axis tracker; wherein said curved trough reflector is a QPT reflector, a cylindrical trough reflector or a curved trough reflector bending to a geometric curve closely; wherein each QPT reflector is made from a flat sheet of mirror reflector bended into desired parabolic curve by a QPT forming technique; said QPT forming technique comprising:
1) the linear span of said bended reflector matches closely to said parabolic curve linear span;
2) said bended reflector width matches closely to said parabolic curve length between said linear span;
3) mounting beams of said bended reflectors are angled to match closely the slope of said parabolic curve at the mounting points; and said QPT reflector is two halves of symmetrical QPT reflectors with junction in the middle at flat angle;
one or more linear solar cells arrays comprising serial connected PV solar cells contained in a linear rectangular solar panel with passive or active heat radiation devices;
wherein said linear solar panels are mounted on said 2-axes or 1-axis tracker frame with manual or automatic adjustable height mounting arms perpendicular to said solar panels;
wherein said curved trough reflectors concentrate sun rays on said linear solar cells arrays to produce photovoltaic power and, optionally, to produce heated water.

**23.** The QPTPV system of claim 21
**characterized in that**
the combination technologies of 1) using said curved trough reflectors mounted on 2-axes or 1-axis solar tracker, 2) using said curved trough reflectors concentrating solar rays onto said linear solar cells array or heating pipe, 3) using output power measurement (or output thermostat temperature in water heating) as feedback to a maximum power pointing algorithm; said combination technologies, or partial combination technologies, is used to save the cost of solar energy production.

**27.** The QPTPV system of claim 21
**characterized in that**
said linear solar panels are replaced with insulated solar heating pipes for the purpose of water heating only.

**28.** The QPTPV system of claim 21
**characterized in that**
said curved trough reflectors mounted on 1-axis tracker are used for solar power (CSP) system with replacement of said elongated linear solar panel by an insulated linear solar heating pipe generating steams for turbine power generation.
